# EUROPEAN PATENT APPLICATION

(11) **EP 2 096 679 A1**
(43) Date of publication of application: **02.09.2009**
(21) Application number: 07831279.0
(22) Date of filing: 06.11.2007
(51) Int. Cl.: H01L 31/04, C23C 16/42, C23C 16/511, H01L 21/316, H01L 21/318, H05H 1/46

(54) **METHOD FOR MANUFACTURING SOLAR CELL AND APPARATUS FOR MANUFACTURING SOLAR CELL**

(30) Priority: 22.11.2006 JP 2006315648
(71) Applicant: Tokyo Electron Limited, Tokyo 107-8481 (JP)
(72) Inventor: MURAKAWA, Shigemi, Tokyo 107-8481 (JP)
(74) Representative: Manitz, Finsterwald & Partner GbR
(86) International application number: PCT/JP2007/071547
(87) International publication number: WO 2008/062663

(57) **Abstract**

There is manufactured a solar cell having a high energy conversion efficiency. A surface layer of a polycrystalline silicon layer serving as a n-type layer formed on a polycrystalline silicon substrate serving as a p-type layer is oxidized by using plasma and then a silicon nitride film is deposited by a CVD process, whereby a passivation film is formed on the surface layer of the polycrystalline silicon layer. The plasma oxidation process is performed by using plasma having a sheath potential equal to or less than about 10 eV at a pressure ranging from about 6.67 Pa to about 6.67 × 10² Pa and at a temperature ranging from about 200°C to about 600°C. A microwave for exciting plasma is supplied into a processing chamber through a slot antenna, and plasma is generated by a surface wave of the microwave.

## Description

### [Technical Field]

The present invention relates to a manufacturing method of a solar cell and a manufacturing apparatus of a solar cell.

### [Background Art]

For example, in a crystalline silicon-based solar cell, a p-n junction is formed on a silicon layer serving as a light absorption layer, and formed on a surface of the silicon layer is a passivation film used for protecting a device or for preventing a light incident on the light absorption layer from being reflected to the outside.

In a conventional way, a passivation film is formed by performing a thermal oxidation process on a surface of a silicon layer. However, if the surface of the silicon layer is thermally oxidized at a high temperature in such way, defects such as a multiple number of holes are generated in an interface between the passivation film formed by the thermal oxidation process and an underlying silicon layer. For this reason, those defects function as a main cause for recombination of carriers such as electrons, so that the carriers are recombined and annihilated, whereby an energy conversion efficiency of a finally fabricated solar cell is lowered. In order to solve this problem, it has been considered to form a silicon nitride film serving as a passivation film on a surface of a silicon layer by a plasma CVD process instead of the thermal oxidation process (see Patent Document 1). Since the silicon nitride film formed by the plasma CVD process is hardly affected by a grain boundary of crystalline silicon, it is possible to suppress an annihilation of the carriers.
Patent Document 1: Japanese Patent Laid-open Publication No. 2005-159171

### [Disclosure of the Invention]

### [Problems to Be Solved by the Invention]

However, when a passivation film is formed by a plasma CVD process as stated above, a silicon nitride film is newly deposited on a silicon layer, so that an interface between the silicon layer and the passivation film becomes discontinuous. For this reason, many crystal defects still exist in the vicinity of the interface between the silicon layer and the passivation film, thereby causing the annihilation of the carriers. Accordingly, a sufficiently high energy conversion efficiency can not be attained even by the plasma CVD process.

In view of the foregoing, there is provided a manufacturing method and a manufacturing apparatus of a solar cell capable of attaining a high energy conversion efficiency.

### [Means for Solving the Problems]

In accordance with one aspect of the present invention, there is provided a solar cell manufacturing method including: forming a passivation film on a surface layer of a silicon layer by performing an oxidation process, a nitridation process or an oxynitriding process on the surface layer of the silicon layer by using plasma.

In accordance with present invention, it is possible to manufacture a solar cell having a high energy conversion efficiency by forming a passivation film through a plasma processing performed on a surface layer of a silicon layer.

In the solar cell manufacturing method, the passivation film may be formed by using plasma having a sheath potential of about 10 eV or less. Herein, the sheath potential implies a potential difference between a space, in which plasma is generated, and a silicon layer.

Further, the passivation film may be formed at a pressure ranging from about 6.67 Pa to about 6.67 × 10² Pa.

Furthermore, the passivation film may be formed at a temperature ranging from about 200°C to about 600°C.

The plasma may be surface wave plasma excited by a microwave.

The microwave for generating the plasma may be supplied through a slot antenna.

The microwave for generating the plasma may be supplied intermittently in a pulse shape having a predetermined period.

In case of performing the oxidation process on a surface layer of a polycrystalline silicon layer, a processing gas containing nitrogen may be introduced into a processing chamber such that a nitrogen atom content ratio in an interface between the polycrystalline silicon layer and the passivation film is equal to or less than about 5 atomic%.

On the passivation film formed on the silicon layer, a passivation film may be further formed by depositing an oxide film, a nitride film or an oxynitride film by a CVD process.

The passivation film may be formed by the CVD process using plasma.

In the CVD process, a bias power may be applied onto a deposition layer of the passivation film.

In at least one of the oxidation process, the nitridation process or the oxynitriding process performed on the surface layer of the silicon layer and the CVD process, a hydrogen gas may be added to a processing gas.

The oxidation process, the nitridation process or the oxynitriding process performed on the surface layer of the silicon layer and the CVD process may be performed within a same processing chamber.

The oxidation process, the nitridation process or the oxynitriding process performed on the surface layer of the silicon layer and the CVD process may be performed in different processing chambers and a solar cell substrate may be transferred between the processing chambers in a vacuum state.

In case of forming the passivation film by performing the oxynitriding process on the surface layer of the silicon layer, a processing gas containing oxygen and nitrogen may be introduced into a processing chamber during the CVD process and a ratio of the nitrogen to the oxygen in the introduced processing gas may be gradually increased such that a content ratio of nitrogen atoms in the passivation film is gradually increased in a deposition direction.

In accordance with another aspect of the present invention, there is provided a solar cell manufacturing apparatus including: a processing unit for forming a passivation film on a surface layer of a silicon layer by performing an oxidation process, a nitridation process or an oxynitriding process on the surface layer of the silicon layer by using plasma.

The processing unit may form the passivation film by using plasma having a sheath potential of about 10 eV or less.

The processing unit may form the passivation film at a pressure ranging from about 6.67 Pa to about 6.67 × 10² Pa.

The processing unit may form the passivation film at a temperature ranging from about 200°C to about 600°C.

The plasma may be surface wave plasma excited by a microwave.

The processing unit may include a slot antenna for supplying the microwave.

The microwave for generating the plasma may be supplied intermittently in a pulse shape having a predetermined period.

In case of performing the oxidation process on a surface layer of a polycrystalline silicon layer, a processing gas containing nitrogen may be introduced into a processing chamber such that a nitrogen atom content ratio in an interface between the polycrystalline silicon layer and the passivation film is equal to or less than about 5 atomic%.

The solar cell manufacturing apparatus may include other processing unit for further forming a passivation film on the passivation film formed on the silicon layer by depositing an oxide film, a nitride film or an oxynitride film by a CVD process.

The other processing unit may form the passivation film by the CVD process using plasma.

The other processing unit may include a power supply for applying a bias power onto a deposition layer of the passivation film.

In at least one of the oxidation process, the nitridation process or the oxynitriding process performed on the surface layer of the silicon layer in the processing unit and the CVD process performed in the other processing unit, a hydrogen gas may be added to a processing gas.

The processing unit and the other processing unit may be connected with each other via a transfer unit for transferring a solar cell substrate in a vacuum state.

In case of forming the passivation film by performing the oxynitriding process on the surface layer of the silicon layer in the processing unit, a processing gas containing oxygen and nitrogen may be introduced into a processing chamber during the CVD process performed in the other processing unit and a ratio of the nitrogen to the oxygen in the introduced processing gas may be gradually increased such that a content ratio of nitrogen atoms in the passivation film is gradually increased in a deposition direction.

### [Effect of the Invention]

In accordance with the present invention, it is possible to manufacture a solar cell having a high energy conversion efficiency.

### [Brief Description of the Drawings]

Fig. 1 is a plane view illustrating a schematic configuration of a manufacturing apparatus of a solar cell in accordance with the present embodiment;
Fig. 2 is a schematic view of a configuration of a processing unit;
Fig. 3 is a plane view of a configuration of a slot plate;
Fig. 4 is a diagram illustrating a longitudinal cross section of a solar cell substrate in which a polycrystalline silicon layer is formed on a polycrystalline silicon substrate;
Fig. 5 is a diagram illustrating a longitudinal cross section of a solar cell substrate in which a passivation film is formed;
Fig. 6 is a graph showing a photoelectric conversion efficiency of a solar cell for each method of forming a passivation film;
Fig. 7 is a graph illustrating a relationship between a sheath potential and a crystal defect density during a plasma processing;
Fig. 8 is a graph illustrating a relationship of an ion energy and an electron temperature with respect to a pressure during a plasma processing;
Fig. 9 is a graph showing a relationship between a nitride atom content ratio and a crystal defect density in an interface between a polycrystalline silicon layer and a passivation film;
Fig. 10 is a graph showing a difference in ion energies between a continuous microwave and a pulse-shaped microwave;
Fig. 11 is a plane view illustrating a schematic configuration of a manufacturing apparatus of a solar cell in accordance with another embodiment;
Fig. 12 is a schematic view of a configuration of another processing unit;
Fig. 13 is a diagram illustrating a longitudinal cross section of a solar cell substrate in which a first passivation film is formed;
Fig. 14 is a diagram illustrating a longitudinal cross section of a solar cell substrate in which a second passivation film is formed;
Fig. 15 is a schematic view of another configuration of a processing unit; and
Fig. 16 is a plane view illustrating an internal configuration of a parallel plate waveguide.

### [Explanation of Codes]

1 : Manufacturing apparatus of a solar cell
14 : Processing unit
42 : Radial line slot antenna
Sp : Polycrystalline silicon substrate
Sn : Polycrystalline silicon layer
A : Passivation film
W : Solar cell substrate

### [Best Mode for Carrying out the Invention]

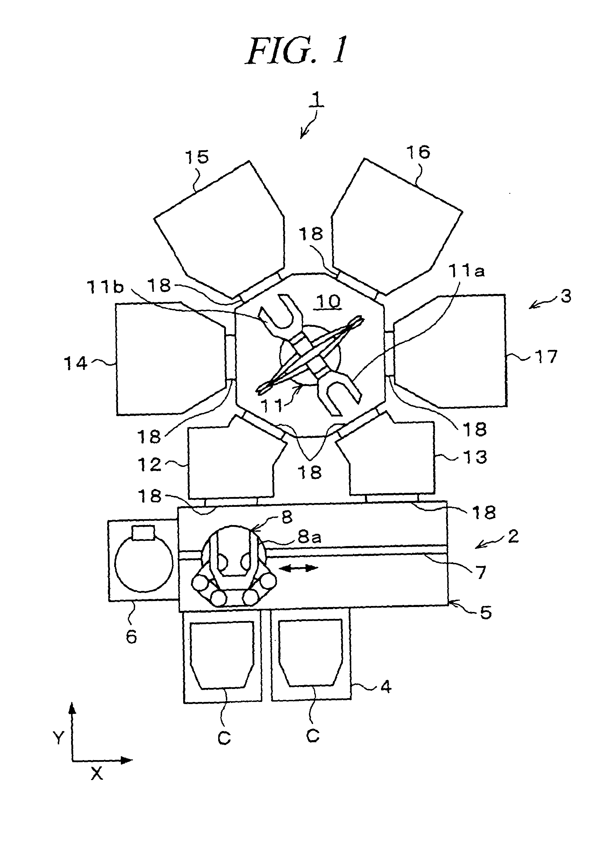

Hereinafter, an embodiment of the present invention will be described in detail with reference to the accompanying drawings. Fig. 1 is a plane view illustrating a schematic configuration of a solar cell manufacturing apparatus 1 in accordance with the present invention.

As illustrated in Fig. 1, the solar cell manufacturing apparatus 1 has, for example, a configuration in which a cassette station 2 for loading/unloading a plurality of solar cell substrates W in a cassette unit and a processing station 3 having various kinds of processing units for performing a single-substrate process on the substrate W are connected with each other as one body.

The cassette station 2 includes, for example, a cassette mounting unit 4, a transfer chamber 5, and an alignment unit 6 for positioning the solar cell substrate W. In the cassette mounting unit 4, cassettes C capable of accommodating a plurality of solar cell substrates W can be mounted side by side in an X direction (in a right and left direction in Fig. 1). The transfer chamber 5 is adjacent to the cassette mounting unit 4 in a positive Y direction (in an upper direction in Fig. 1). In the transfer chamber 5, there are installed a transfer rail 7 extending, for example, in the X direction and a substrate transfer device 8 moving along the transfer rail 7. The alignment unit 6 is adjacent to the transfer chamber 5 in a negative X direction (in the left direction in Fig. 1). The substrate transfer device 8 installed in the transfer chamber 5 includes a multi-joint transfer arm 8a which is pivotable, extensible and contractible, and can transfer the solar cell substrate W with respect to the cassette C in the cassette mounting unit 4, the alignment unit 6 and load lock chambers 12 and 13 of the processing station 3 to be described later.

At a central portion of the processing station 3, there is installed a central transfer chamber 10 as a transfer unit capable of depressurizing its inside. Installed within the central transfer chamber 10 is a substrate transfer mechanism 11. The central transfer chamber 10 is formed in an approximately octagon shape when viewed from the top, for example, and is surrounded by and connected with the load lock chambers 12 and 13 and four, for example, processing units 14, 15, 16 and 17. The substrate transfer mechanism 11 includes two transfer arms 11a and 11b which are pivotable, extensible and contractible, and can transfer the solar cell substrate W with respect to the load lock chambers 12 and 13 and the processing units 14 to 17 surrounding the central transfer chamber 10.

The load lock chambers 12 and 13 are disposed between the central transfer chamber 10 and the transfer chamber 5 of the cassette station 2 and connect the central transfer chamber 10 with the transfer chamber 5. The load lock chambers 12 and 13 can include a non-illustrated mounting unit for mounting the solar cell substrate W thereon and maintain its inside in a depressurized atmosphere.

Each gate valve 18 is installed between the transfer chamber 5 and the respective load lock chambers 12 and 13, between the central transfer chamber 10 and the respective load lock chambers 12 and 13, and between the central transfer chamber 10 and the respective processing units 14 to 17.

The processing unit 14 is a plasma processing apparatus for performing an oxidation process, a nitridation process or an oxynitriding process on the solar cell substrate W by generating plasma using a radial line slot antenna.

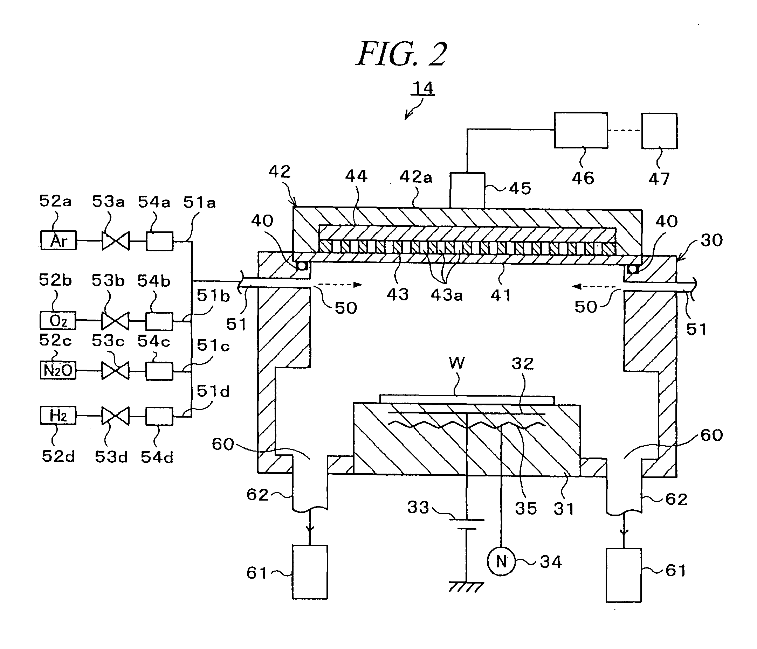

The processing unit 14 includes, for example, as illustrated in Fig. 2, a cylindrical processing chamber 30 having an open top surface and a bottom surface. The processing chamber 30 is made of, e.g., an aluminum alloy. The processing chamber 30 is grounded. Installed at a central portion of a bottom portion of the processing chamber 30 is a mounting table 31 for mounting, e.g., the solar cell substrate W thereon.

In the mounting table 31, an electrode plate 32, for example, is embedded, and the electrode plate 32 is connected with a DC power supply 33 installed at the outside of the processing chamber 30. An electrostatic force is generated on a surface of the mounting table 31 by the DC power supply 33, thereby electrostatically attracting the solar cell substrate W on the mounting table 31. A heater 35 for generating heat in response to a power feed from a heater power supply 34 is embedded in the mounting table 31, so that it is possible to heat the solar cell substrate W on the mounting table 31 to a predetermined temperature.

Installed at the opening in the top part of the processing chamber 30 is a microwave transmission plate 41 made of a dielectric material such as alumina (Al₂O₃) or a quartz glass via a sealing member 40 such as an O-ring for securing airtightness. The inside of the processing chamber 30 is airtightly closed by the microwave transmission plate 41. Installed at the top portion of the microwave transmission plate 41 is a radial line slot antenna 42 providing a microwave for generating plasma.

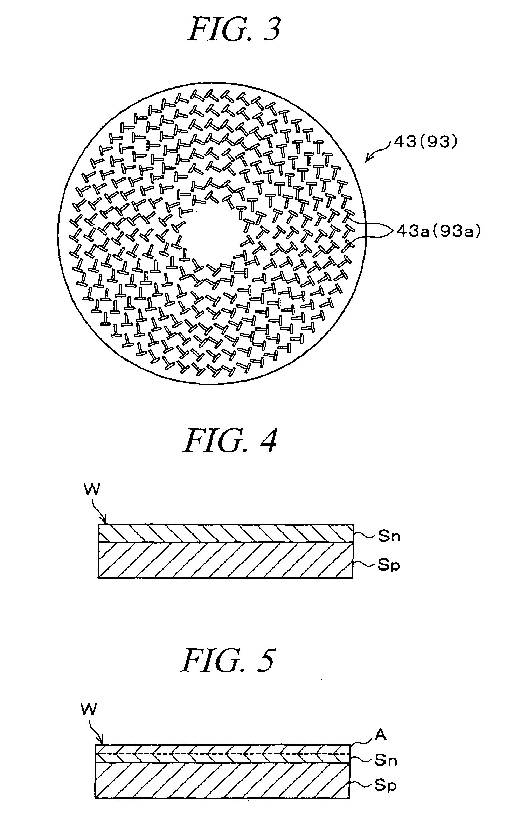

The radial line slot antenna 42 includes a substantially cylindrical case 42a having an open bottom surface on which there is formed a disc-shaped slot plate 43 having a plurality of slots therein. The slot plate 43 is a gold- or silver-plated copper or aluminum plate in which a plurality of microwave radiation holes 43a serving as slots are formed. The microwave radiation holes 43a adjacent to each other are formed in, e.g., a T-shape as illustrated in Fig. 3 and these T-shaped microwave radiation holes 43a are arranged in a concentric circular shape. A length of the microwave radiation hole 43a or a distance between them is determined based on a wavelength λ of a microwave. For example, the distance between the microwave radiation holes 43a is set to be about (1/2)λ or λ. Further, a shape of the microwave radiation holes 43a is not limited to a T-shape, so they can be formed in other shapes such as a circle, a circular arc or the like. Furthermore, an arrangement of the microwave radiation holes 43a is not limited to a concentric circular shape, so they can be arranged in a spiral shape, a grid pattern, a random manner, a radial shape, or the like.

Installed at the top portion of the slot plate 43 is a wavelength shortening plate 44 made of a low-loss dielectric material as illustrated in Fig. 2. Since a wavelength of the microwave is lengthened in a vacuum state, the wavelength shortening plate 44 shortens a wavelength of the microwave to control a generation state of plasma.

Formed at a central portion of the case 42a of the radial line slot antenna 42 is an opening which is connected with a coaxial waveguide 45. The coaxial waveguide 45 is connected with a microwave oscillation apparatus 46 for generating a microwave of, e.g., 2.45 GHz. The microwave oscillation apparatus 46 is provided with a microwave oscillation control unit 47 for controlling ON·OFF or output of the microwave oscillation.

For example, in a sidewall of the processing chamber 30, there is formed a processing gas supply opening 50 which is connected with, e.g., a processing gas supply pipe 51 leading to the outside of the processing chamber 30. The processing gas supply pipe 51 is branched into plural, e.g., four branch pipes 51a, 51b, 51c and 51d, which are connected with gas supply sources 52a, 52b, 52c and 52d respectively. Installed at the respective branch pipes 51a to 51d are valves 53a, 53b, 53c and 53d and mass flow controllers 54a, 54b, 54c and 54d. With this configuration, it is possible to supply a predetermined processing gas into the processing chamber 30 at a predetermined flow rate. In the present embodiment, sealed into, e.g., the gas supply source 52a is a rare gas, e.g., an Ar gas for generating plasma, and sealed into the gas supply source 52b is an oxygen (O₂) gas. Further, sealed into the gas supply source 52c is a dinitrogen monoxide (N₂O) gas, and sealed into the gas supply source 52d is a hydrogen (H₂) gas. Furthermore, the number of the gas supply sources and gas species can be appropriately changed depending on kinds of the processing gases.

For example, installed at both sides of the mounting table 31 on the bottom portion of the processing chamber 30 are exhaust openings 60 for exhausting an internal atmosphere of the processing chamber 30. The exhaust openings 60 are connected with gas exhaust units 61 such as a turbo-molecular pump via exhaust pipes 62. By the exhaustion through the exhaust openings 60, the inside of the processing chamber 30 can be depressurized to a predetermined pressure.

Since the configuration of the processing units 15 to 17 are the same as that of the above-described processing unit 14, an explanation thereof is omitted.

Hereinafter, there will be explained a process for forming a passivation film of a solar cell, which is performed in the above-stated solar cell manufacturing apparatus 1.

In the present embodiment, for example, as illustrated in Fig. 4, formed on a solar cell substrate W is a light absorption layer of a p-n junction including a polycrystalline silicon substrate Sp serving as a p-type layer and a polycrystalline silicon layer Sn serving as a n-type layer formed thereon. A passivation film is formed on a surface of the polycrystalline silicon layer Sn.

In accordance with the process for forming the passivation film, each one of the solar cell substrates W is unloaded from the cassette C of the cassette station 2 by the substrate transfer device 8 illustrated in Fig. 1 and then is transferred to the alignment unit 6. The solar cell substrate W is position-adjusted by the alignment unit 6; transferred to the load lock chamber 12 by the substrate transfer device 8; and then transferred to, e.g., the processing unit 14 by the substrate transfer mechanism 11 via the central transfer chamber 10. At this time, the inside of the central transfer chamber 10 is maintained in a vacuum state and thus the solar cell substrate W passing through the inside of the central transfer chamber 10 is transferred in a vacuum state.

The solar cell substrate W transferred to the processing unit 14 is attracted onto and held by the mounting table 31 as illustrated in Fig. 2. Then, the solar cell substrate W is heated by the heater 35 to a temperature ranging from about 200°C to about 600°C, for example, 350°C. Subsequently, the inside of the processing chamber 30 is controlled to a pressure ranging from about 50 mTorr (6.67 Pa) to about 5 Torr (6. 67 × 10² Pa), for example, 100 mTorr (13.3 Pa), and then a gas mixture of an argon gas and an oxygen gas is introduced to the inside of the processing chamber 30 from the gas supply opening 50.

Thereafter, a microwave is introduced to the inside of the processing chamber 30 from the radial line slot antenna 42. By introduction of the microwave, the processing gas in the processing chamber 30 is excited and plasma is generated within the processing chamber 30. At this time, the microwave passes through the slot plate 43 and forms a surface wave by which high density plasma is generated right under the microwave transmission plate 41. Further, a sheath potential between a plasma generation space within the processing chamber 30 and a surface of the solar cell substrate W is maintained at 10 eV or less. On the surface of the solar cell substrate W, a surface layer of the polycrystalline silicon layer Sn is oxidized by an action of the plasma containing oxygen atoms. Accordingly, as illustrated in Fig. 5, formed on a surface of the polycrystalline silicon layer Sn is a passivation film A made of a silicon oxide film.

When the passivation film A having a desired thickness is formed by performing a plasma oxidation process for a predetermined time, the microwave or the processing gas is not any longer supplied and the process for forming the passivation film is ended.

Then, the solar cell substrate W is unloaded from the processing unit 14 by the substrate transfer mechanism 11 and transferred to the load lock chamber 13 via the central transfer chamber 10. Subsequently, the solar cell substrate W is returned to the cassette C by the substrate transfer device 8 and a series of processes is ended.

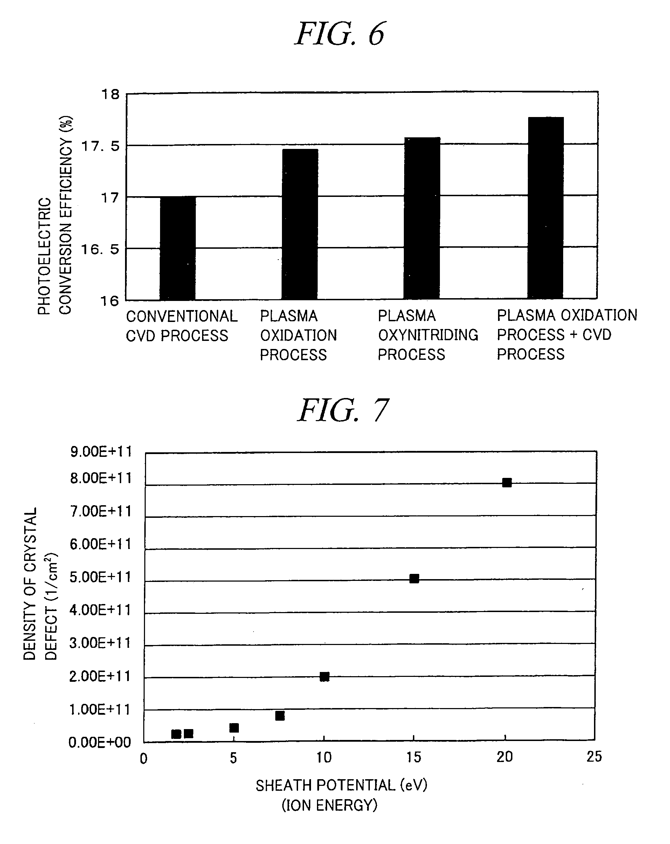

In accordance with the above-stated embodiment, since the passivation film A is formed by using the plasma oxidation process, the polycrystalline silicon layer Sn and the passivation film A have a smooth and continuous interface therebetween without a grain boundary in comparison with a case using a conventional CVD process. As a result, crystal defects in the vicinity of the interface between the polycrystalline silicon layer Sn and the passivation film A decrease, so that energy carriers are rarely annihilated, whereby it is possible to manufacture a solar cell having a higher energy conversion efficiency in comparison with a conventional one. Fig. 6 illustrates a photoelectric conversion efficiency of a solar cell for each method for forming a passivation film. A photoelectric conversion efficiency is highly improved in a case using the plasma oxidation process as stated in the present embodiment as compared to a case using the conventional CVD process.

In regard to a relationship between a sheath potential (ion energy) on the surface of the solar cell substrate W and a crystal defect of the polycrystalline silicon layer Sn during a plasma processing, it is found that a density of crystal defects decreases extremely below or equal to 2 × 10⁺¹¹ (1/cm²) when a sheath potential is equal to or less than 10 eV as illustrated in Fig. 7. In the present embodiment, the plasma processing is performed at a low ion energy having a sheath potential equal to or less than 10 eV, so that it is possible to reduce the crystal defects of the polycrystalline silicon layer Sn and manufacture a solar cell having a high photoelectric conversion efficiency.

In particular, by using the radial line slot antenna 42 as a microwave supply unit, the plasma is concentrated right under the microwave transmission plate 41, so that the sheath potential of the surface of the solar cell substrate W can be kept stably low.

When a plasma processing is performed at a temperature less than 200°C, it is found that water or an organic material adhered to the surface of the polycrystalline silicon layer Sn is introduced into the film. Further, when a plasma processing is performed at a temperature higher than a 600°C, the polycrystalline silicon layer Sn is crystallized again. In the present embodiment, the plasma processing is performed at a temperature ranging from about 200°C to about 600°C, so that it is possible to form a passivation film A of a good quality containing little impurities therein.

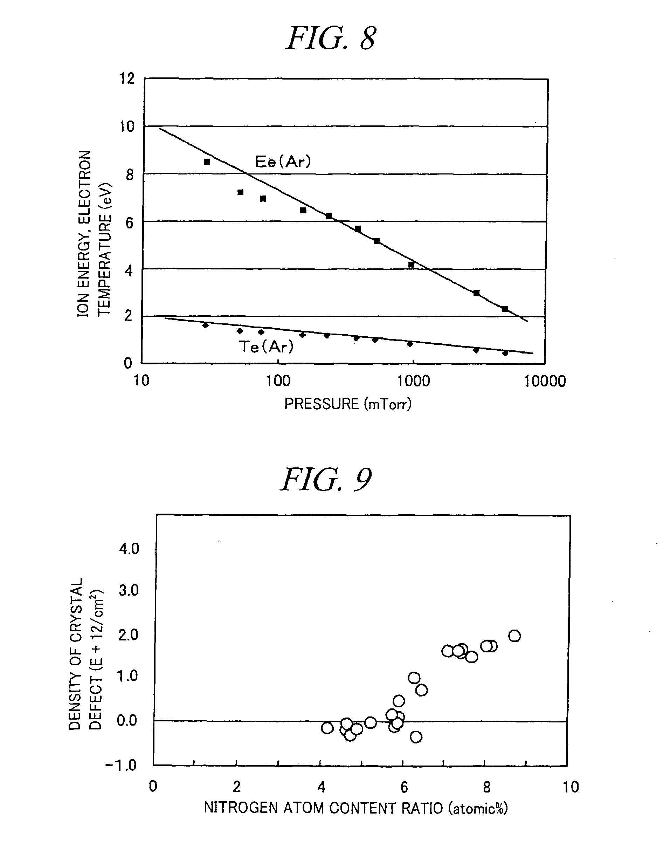

As illustrated in Fig. 8, it is found that a plasma ion energy Ee or a plasma electron temperature Te can be reduced by increasing an internal pressure of the processing chamber 30 during the plasma processing. As performed in the present embodiment, the polycrystalline silicon layer Sn can be oxidized at a low ion energy by setting the internal pressure of the processing chamber 30 to be equal to or more than 50 mTorr (6.67 Pa) during the processing. As a result, the crystal defects of the polycrystalline silicon layer Sn can be reduced and thus the solar cell having a high photoelectric conversion efficiency can be manufactured. However, if the internal pressure of the processing chamber 30 is set too high during the processing, the ion energy is too much decreased and thus a rate of plasma oxidation decreases remarkably. In accordance with the present embodiment, it is possible to avoid a remarkable decrease of the plasma oxidation rate by maintaining the internal pressure of the processing chamber 30 to be equal to or less than 5 Torr (6.67 × 10² Pa).

In the above-stated embodiment, although the oxygen gas and the argon gas have been supplied as the processing gas, it may be also possible to maintain a nitrogen atom content ratio in the interface between the polycrystalline silicon layer Sn and the passivation film A to be equal to or less than 5 atomic% by adding nitrogen to the processing gas. In order to add the nitrogen to the processing gas, a nitrogen (N₂) gas or an ammonia (NH₃) gas may be added to the processing gas, or a N₂O gas, instead of the oxygen gas, may be used as the processing gas. In this case, since the nitrogen atoms are introduced to the interface of the polycrystalline silicon layer Sn, the nitrogen atoms react selectively on the crystal defects formed in the interface between the polycrystalline silicon layer Sn and the passivation film A, which is an oxide film, and thus the nitrogen atoms restore the crystal defects. As a result, a final amount of the crystal defects decreases, so that it is possible to improve a photoelectric conversion efficiency of the solar cell. Further, it is found that when the nitrogen atom content ratio is more than 5 atomic% as illustrated in Fig. 9, which means that the nitrogen atoms are oversupplied, the crystal defects in the interface of the polycrystalline silicon layer Sn increase, on the contrary. Accordingly, the crystal defects can be appropriately restored by the nitrogen atoms by maintaining the nitrogen atom content ratio to be equal to or less than 5 atomic%.

In the above-stated embodiment, though the passivation film A has been formed by performing an oxidation process on the polycrystalline silicon layer Sn, it may be also possible to form a passivation film by performing an oxynitriding process. In this case, a N₂O gas may be supplied instead of the oxygen gas to the processing unit 14. Even in this case, it is possible to manufacture a solar cell having a high photoelectric conversion efficiency as compared to a case using a conventional CVD process, as illustrated in Fig. 6. Furthermore, it may be also possible to form a passivation film by performing a nitridation process on the polycrystalline silicon film Sn by supplying the nitrogen gas instead of the oxygen gas.

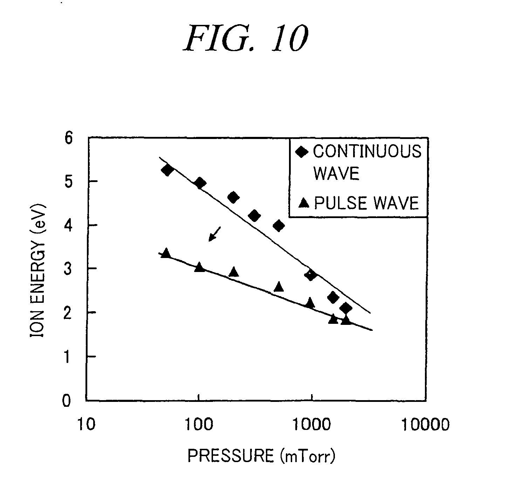

In the above-stated embodiment, though the microwave for generating plasma has been continuously supplied during the processing, it may be also possible to supply it intermittently in a pulse shape having a predetermined period. In this case, for example, the microwave oscillation apparatus 46 generates a microwave formed in a pulse shape having a predetermined period under control of the microwave oscillation control unit 47 and the radial line slot antenna 42 supplies the pulse-shaped microwave into the processing chamber 30. For example, the microwave is supplied such that a pulse frequency is about 50 kHz and a duty ratio (ratio of ON time to total ON·OFF time) is about 50%. As illustrated in Fig. 10, it is found that a plasma ion energy is smaller in case that a pulse-shaped microwave (pulse wave) is supplied as compared to a case that a continuous microwave (continuous wave) is supplied. Therefore, it is possible to reduce the defects in the interface between the polycrystalline silicon layer Sn and the passivation film A by supplying the pulse-shaped microwave and to manufacture a solar cell having a high photoelectric conversion efficiency. Furthermore, in this example, though the pulse frequency is about 50 kHz and the duty ratio is about 50%, it is found that as long as a pulse frequency is in a range from about 10 kHz to about 1 MHz and a duty ratio is in a range from about 20% to about 80%, it has an effect of reduction in crystal defects in comparison with the continuous wave.

In the above-stated embodiment, though the passivation film A has been formed on the surface layer of the polycrystalline silicon layer Sn by, e.g., the plasma oxidation process, it may be also possible to deposit an additional passivation film on a top surface of the passivation film A by the CVD process.

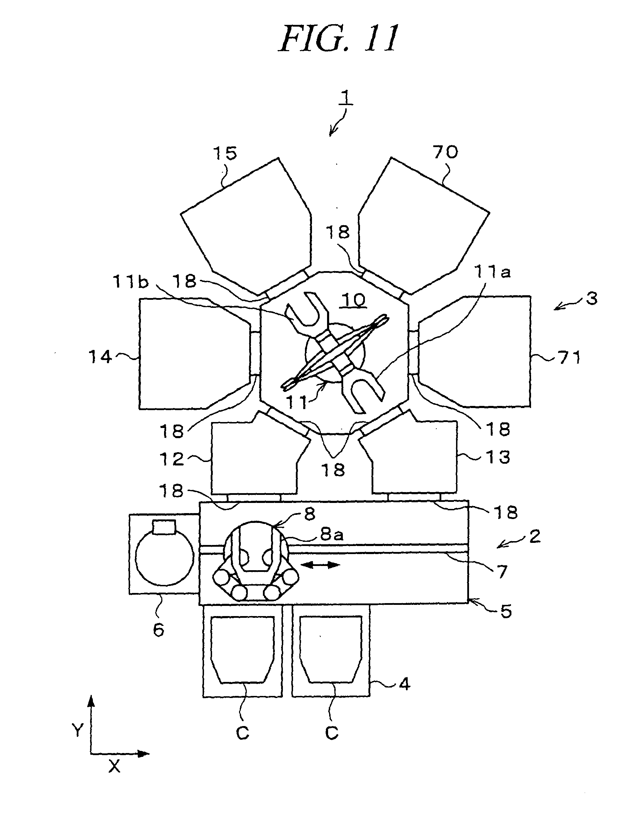

Fig. 11 provides such an embodiment. The solar cell manufacturing apparatus 1 includes other processing units 70 and 71 for performing the CVD process. The other processing units 70 and 71, instead of the above-stated processing units 16 and 17, are connected with the central transfer chamber 10.

For example, the other processing unit 70 is a plasma CVD apparatus for forming a film on a solar cell substrate W by generating plasma using a radial line slot antenna.

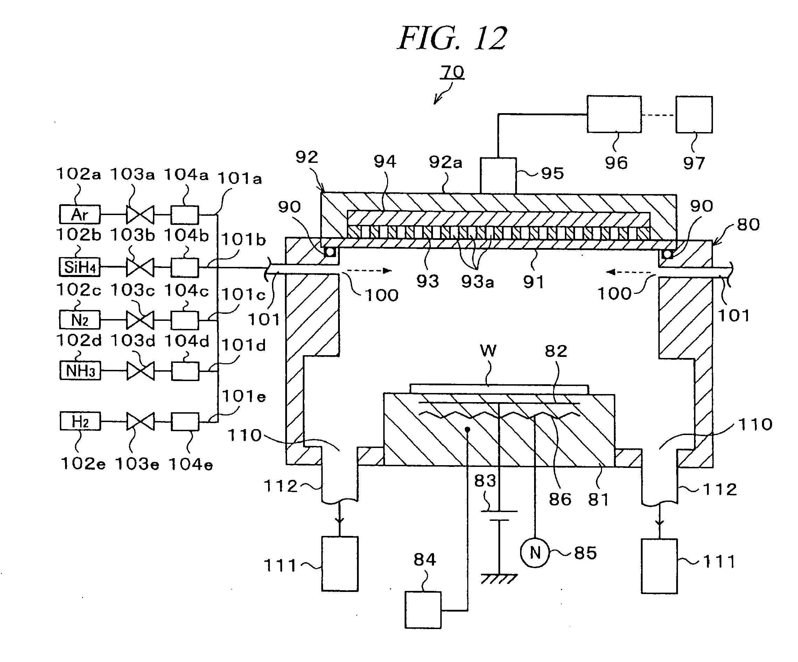

The configuration of the other processing unit 70 is the same as that of the above-stated processing unit 14 except for that it is connected with a high frequency power supply so as to apply a bias power onto, e.g., a mounting table and it uses a different processing gas. That is, the other processing unit 70 includes a cylindrical processing chamber 80 having an open top surface and a bottom surface, and on a bottom portion of the processing chamber 80, there is installed a mounting table 81 as shown in Fig. 12.

Embedded in the mounting table 81 is an electrode plate 82 which is connected with a DC power supply 83. Further, the mounting table 81 is connected with a high frequency power supply 84 for applying a bias power onto, e.g., the solar cell substrate W. A heater 86 for generating heat in response to a power feed from a heater power supply 85 is embedded in the mounting table 81, so that the solar cell substrate W on the mounting table 81 can be heated to a predetermined temperature.

Installed at the opening in the top part of the processing chamber 80 is a microwave transmission plate 91 via, e.g., a sealing member 90. The inside of the processing chamber 80 is airtightly closed by the microwave transmission plate 91. Installed at the top portion of the microwave transmission plate 91 is a radial line slot antenna 92.

The radial line slot antenna 92 includes a substantially cylindrical case 92a having an open bottom surface on which a disc-shaped slot plate 93 is installed. The slot plate 93 has a plurality of microwave radiation holes 93a serving as slots. The microwave radiation holes 93a adjacent to each other are formed in, e.g., a T-shape as illustrated in Fig. 3 and these T-shaped microwave radiation holes 93a are arranged in a concentric circular shape. A length of the microwave radiation hole 93a or a distance between them is determined according to a wavelength λ of a microwave. For example, the distance between the microwave radiation holes 93a is set to be about (1/2)λ or λ.

Installed at the top portion of the slot plate 93 is a wavelength shortening plate 94 made of a low-loss dielectric material as illustrated in Fig. 12.

Formed at a central portion of the case 92a of the radial line slot antenna 92 is an opening which is connected with a coaxial waveguide 95. The coaxial waveguide 95 is connected with a microwave oscillation apparatus 96 for generating a microwave of, e.g., 2.45 GHz. The microwave oscillation apparatus 96 is provided with a microwave oscillation control unit 97 for controlling ON·OFF or output of the microwave oscillation.

For example, formed in a sidewall of the processing chamber 80 is a processing gas supply opening 100 which is connected with, e.g., a processing gas supply pipe 101 leading to the outside of the processing chamber 80. The processing gas supply pipe 101 is branched into plural, e.g., five branch pipes 101a, 101b, 101c, 101d and 101e, which are connected with gas supply sources 102a, 102b, 102c, 102d and 102e respectively. Installed at the respective branch pipes 101a to 101e are valves 103a, 103b, 103c, 103d and 103e and mass flow controllers 104a, 104b, 104c, 104d and 104e. With this configuration, it is possible to supply a predetermined processing gas into the processing chamber 30 at a predetermined flow rate. In the present embodiment, sealed into, e.g., the gas supply source 102a is a rare gas, e.g., an Ar gas, and sealed into the gas supply source 102b is a silane (SiH₄) gas. Further, sealed into the gas supply sources 102c, 102d and 102e are a nitrogen (N₂) gas, an ammonia (NH₃) gas and a hydrogen (H₂) gas respectively.

For example, installed at both sides of the mounting table 81 on the bottom portion of the processing chamber 80 are exhaust openings 110 which are connected with gas exhaust units 111 such as a turbo-molecular pump via exhaust pipes 112. By the exhaustion through the exhaust openings 110, the inside of the processing chamber 80 can be depressurized to a predetermined pressure.

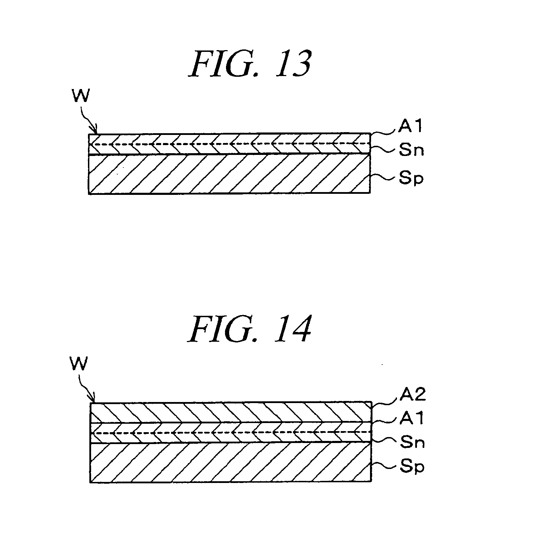

Hereinafter, there will be explained a process for forming a passivation film. The solar cell substrate W having the polycrystalline silicon substrate Sp and the polycrystalline silicon layer Sn formed thereon as illustrated in Fig. 4 is transferred to the alignment unit 6 from the cassette C by the substrate transfer device 8 in the same manner as the above-described embodiment. Thereafter, the solar cell substrate W is transferred to the load lock chamber 12 by the substrate transfer device 8 and transferred to, e.g., the processing unit 14 by the substrate transfer mechanism 11 via the central transfer chamber 10. In the solar cell substrate W transferred to the processing unit 14, a surface layer of the polycrystalline silicon layer Sn is oxidized by the plasma processing in the same manner as the aforementioned embodiment. Accordingly, as shown in Fig. 13, a passivation film Al is formed on the surface of the polycrystalline silicon layer Sn.

Then, the solar cell substrate W is unloaded from the processing unit 14 by the substrate transfer mechanism 11 and transferred to, e.g., the other processing unit 70 via the central transfer chamber 10. At this time, the solar cell substrate W is transferred in a vacuum state in order not to be exposed to the air.

The solar cell substrate W transferred to the other processing unit 70 is attracted onto and held by the mounting table 81 as illustrated in Fig. 12. Then, the solar cell substrate W is heated by the heater 86 to a temperature ranging from about 200°C to about 600°C. Subsequently, the inside of the processing chamber 80 is controlled to a pressure ranging from about 5 mTorr to about 5 Torr, and then a gas mixture of an argon gas, a silane gas and a nitrogen gas is introduced to the inside of the processing chamber 80 from the gas supply opening 100.

Thereafter, a microwave is introduced to the inside of the processing chamber 80 from the radial line slot antenna 92. By the introduction of the microwave, the gas in the processing chamber 80 is excited into plasma within the processing chamber 80. At this time, the microwave passes through the slot plate 93 and forms a surface wave by which high density plasma is generated right under the microwave transmission plate 91. Further, the high frequency power supply 84 applies a bias power of 20V or more onto the solar cell substrate W on the mounting table 81. On the surface of the solar cell substrate W, a silicon nitride film is deposited on a surface of a first passivation film Al by an action of plasma, thereby forming a second passivation film A2 as illustrated in Fig. 14. As a result, there is formed a passivation film Al + A2 having a predetermined thickness of, e.g., about 10 nm or more on the whole.

When the passivation film having a desired thickness is formed by performing a plasma CVD process for a predetermined time, the microwave or the processing gas is not any longer supplied and the process for forming the passivation film is ended.

Thereafter, the solar cell substrate W is unloaded from the other processing unit 70 by the substrate transfer mechanism 11 and then transferred to the load lock chamber 13 via the central transfer chamber 10. Then, the solar cell substrate W is returned to the cassette C by the substrate transfer device 8 and a series of processes is ended.

In accordance with this embodiment, by forming the second passivation film A2 on the first passivation film Al by the CVD process, even if the passivation film having a satisfactory thickness can not be obtained by performing the plasma oxidation process only, it is possible to form a passivation film having a sufficient thickness by the subsequent CVD process. As a result, the passivation film can fully function as, e.g., an anti-reflection film. Furthermore, the passivation film having a satisfactory strength may be obtained. Moreover, in this embodiment, by forming the silicon nitride film having a higher reflectivity on the silicon oxide film serving as the first passivation film A1, an anti-reflection function of the passivation film can be more improved.

Further, like this embodiment, in case of forming a passivation film by performing the plasma oxidation process on the polycrystalline silicon layer Sn and then forming a nitride film thereon by the CVD process, it is possible to manufacture a solar cell having a high photoelectric conversion efficiency in comparison with a case in which only the conventional CVD process is performed as illustrated in Fig. 6, or a case in which only the above-stated plasma oxidation process and plasma nitridation process are performed. It can be deemed that since the silicon nitride film formed by the CVD process has a higher refractive index than the silicon oxide film, it becomes easy to confine a light in the passivation film by the combination of the plasma oxidation process and the CVD process and thus the photoelectric conversion efficiency is improved.

By connecting the processing unit 14 with the other processing unit 70 via the central transfer chamber 10 and transferring the solar cell substrate W from the processing unit 14 to the other processing unit 70 in a vacuum state, it is possible to prevent the film quality from being deteriorated due to, for example, water adhered thereonto when the solar cell substrate W is exposed to the air. Furthermore, it may be possible to perform both the process for forming the first passivation film A1 and the process for forming the second passivation film A2 within the same processing chamber, and for example, within the processing chamber 80 of the other processing unit 70, it may be possible to form the first passivation film Al by performing the above-stated plasma oxidation process and then form the second passivation film A2 by performing the plasma CVD process.

Like the above-described embodiment, in case that the first passivation film Al is an oxide film, an oxygen gas in addition to a nitrogen gas is introduced as a processing gas for the CVD process and a ratio of a nitrogen to an oxygen increases gradually when introducing the processing gas, whereby it may be possible to gradually increase a content ratio of nitrogen atoms in the second passivation film A2 in a deposition direction. In this case, for example, in the CVD process, a small amount of the nitrogen gas as compared to the oxygen gas is introduced in the beginning; then the introduced amount of the nitrogen gas is increased as the introduced amount of the oxygen gas is decreased; and finally, only the nitrogen gas is introduced thereto. In this way, a film composition of the second passivation film A2 is gradually changed from the silicon oxide film to the silicon nitride film, so that a film composition of the first passivation film A1, which is the silicon oxide film, becomes generally continuous with that of the second passivation film A2. Accordingly, a grain boundary in the passivation film decreases, so that crystal defects can be reduced. Furthermore, this embodiment can be applied to a case in which the first passivation film Al is an oxynitride film.

Further, in the above-described embodiment, though the SiH₄ (silane) gas is used as the processing gas for the CVD process, it may be also possible to use other gases such as a Si₂H₆ (disilane) gas instead. Moreover, it may be possible to form an oxide film or an oxynitirde film, instead of the nitride film, on the first passivation film Al by changing the processing gas for the CVD process.

In at least one of the process for forming the first passivation film Al on the polycrystalline silicon layer Sn and the CVD process for forming the second passivation film A2 which are described in the foregoing embodiment, it may be possible to add a hydrogen gas to the processing gas. In this case, since the hydrogen atoms react selectively on the crystal defects formed in the passivation film and in the interface between the silicon layer and the passivation film, the crystal defects can be restored. As a result, a solar cell having a much higher photoelectric conversion efficiency can be fabricated.

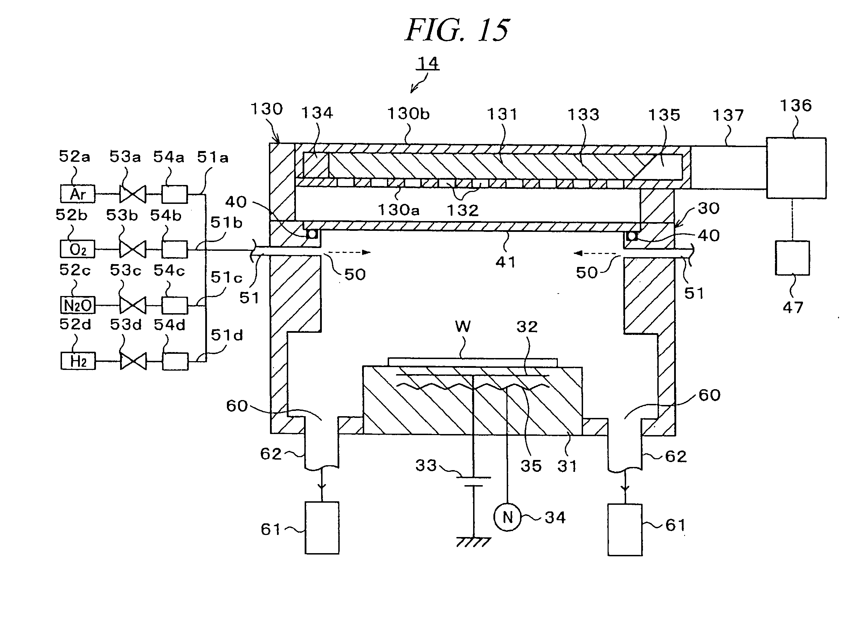

Though the processing units 14 to 17 and the other processing units 70 and 71 described in the foregoing embodiment include the above-stated radial line slot antenna, they may include a slot antenna having a different configuration. For example, the processing unit 14 includes a parallel plate waveguide slot antenna (hereinafter, referred to as "parallel plate antenna") 130 at the top portion of the microwave transmission plate 41 as illustrated in Fig. 15.

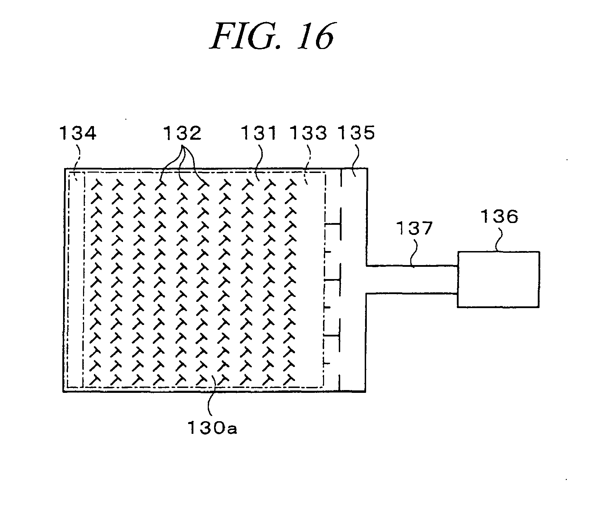

The parallel plate antenna 130 is an antenna in which slots are formed in one of two plates constituting a parallel plate waveguide. The parallel plate antenna 130 includes a first waveguide plate 130a having a square-shape at a lower side thereof and a second waveguide plate 130b having a square-shape at a upper side thereof, which are disposed parallel to each other. A parallel plate waveguide 131 is formed at a gap between the first and the second waveguide plates 130a and 130b. In the first waveguide plate 130a, a plurality of microwave radiation holes 132 serving as slots is formed. The microwave radiation holes 132 adjacent to each other are formed in, e.g., a T-shape as illustrated in Fig. 16 and these T-shaped microwave radiation holes 132 are arranged lengthwise and breadthwise in a regular line. A length of the microwave radiation holes 132 or an arrangement distance between them is determined according to a wavelength λ of a microwave in the parallel plate waveguide 131. For example, the distance between the microwave radiation holes 132 is set to be a natural number multiple of λ. Further, a shape of the microwave radiation holes 132 is not limited to a T-shape, so they can be formed in other shapes such as circle, a circular arc or the like. Furthermore, arrangement of the microwave radiation holes 132 is not limited to a lengthwise and breadthwise arrangement, so they can be arranged in a concentric circle shape, a spiral shape, a random manner, a radial shape, or the like.

As illustrated in Fig. 15, installed within the parallel plate waveguide 131 is a wavelength shortening member 133 made of a dielectric material. A wavelength of a microwave introduced to the parallel plate waveguide 131 can be shortened by the wavelength shortening member 133, whereby it is possible to control a generation state of plasma. Further, at one end portion within the parallel plate waveguide 131, there is formed a microwave absorption member 134.

In the vicinity of the other end portion opposite to the microwave absorption member 134 within the parallel plate waveguide 131, there is formed a microwave distribution unit 135 for distributing the introduced microwave. The microwave distribution unit 135 is connected with a waveguide 137 which is connected with a microwave oscillation apparatus 136 for generating a microwave of, e.g., 2.45 GHz. Since a configuration of the other parts of the processing unit 14 is the same as that of the processing unit 14 described in the foregoing embodiment, so that they are assigned the same reference numerals and a detailed explanation thereof is omitted.

In accordance with the processing unit 14, the microwave generated from the microwave oscillation apparatus 136 is introduced to the parallel plate waveguide 131 of the parallel plate antenna 130; passes through the microwave radiation hole 132 of the first waveguide plate 130a; and then is introduced into the processing chamber 30 via the microwave transmission plate 41. Accordingly, formed within the processing chamber 30 is a surface wave of the microwave by which high density plasma is generated right under the microwave transmission plate 41.

Further, the processing units 15, 16 and 17 and the other processing units 70 and 71 may include the parallel plate antenna 130 as well.

Though the above description is provided for the purpose of illustration of the embodiments of the present invention, it is clear that the above-described embodiments do not limit the present invention. It would be understood by those skilled in the art that all modifications and embodiments conceived from the meaning and scope of the claims and their equivalents are included in the scope of the present invention. For example, the present embodiment provides an example of forming a passivation film on a polycrystalline silicon layer, but the present invention can be applied to a case of forming a passivation film on a monocrystalline silicon layer, an amorphous silicon layer, or a silicon layer in which polycrystalline silicon and amorphous silicon co-exist.

### [Industrial Applicability]

The present invention is useful in manufacturing a solar cell having a high energy conversion efficiency.

## Claims

1. A solar cell manufacturing method comprising:
forming a passivation film on a surface layer of a silicon layer by performing an oxidation process, a nitridation process or an oxynitriding process on the surface layer of the silicon layer by using plasma.

2. The solar cell manufacturing method of claim 1, wherein the passivation film is formed by using plasma having a sheath potential of about 10 eV or less.

3. The solar cell manufacturing method of claim 1, wherein the passivation film is formed at a pressure ranging from about 6.67 Pa to about 6.67 × 10² Pa.

4. The solar cell manufacturing method of claim 1, wherein the passivation film is formed at a temperature ranging from about 200°C to about 600°C.

5. The solar cell manufacturing method of claim 1, wherein the plasma is surface wave plasma excited by a microwave.

6. The solar cell manufacturing method of claim 5, wherein the microwave for generating the plasma is supplied through a slot antenna.

7. The solar cell manufacturing method of claim 5, wherein the microwave for generating the plasma is supplied intermittently in a pulse shape having a predetermined period.

8. The solar cell manufacturing method of claim 1, wherein in case of performing the oxidation process on a surface layer of a polycrystalline silicon layer, a processing gas containing nitrogen is introduced into a processing chamber such that a nitrogen atom content ratio in an interface between the polycrystalline silicon layer and the passivation film is equal to or less than about 5 atomic%.

9. The solar cell manufacturing method of claim 1, wherein on the passivation film formed on the silicon layer, a passivation film is further formed by depositing an oxide film, a nitride film or an oxynitride film by a CVD process.

10. The solar cell manufacturing method of claim 9, wherein the passivation film is formed by the CVD process using plasma.

11. The solar cell manufacturing method of claim 10, wherein in the CVD process, a bias power is applied onto a deposition layer of the passivation film.

12. The solar cell manufacturing method of claim 10, wherein in at least one of the oxidation process, the nitridation process or the oxynitriding process performed on the surface layer of the silicon layer and the CVD process, a hydrogen gas is added to a processing gas.

13. The solar cell manufacturing method of claim 10, wherein the oxidation process, the nitridation process or the oxynitriding process performed on the surface layer of the silicon layer and the CVD process are performed within a same processing chamber.

14. The solar cell manufacturing method of claim 10, wherein the oxidation process, the nitridation process or the oxynitriding process performed on the surface layer of the silicon layer and the CVD process are performed in different processing chambers and a solar cell substrate is transferred between the processing chambers in a vacuum state.

15. The solar cell manufacturing method of claim 9, wherein in case of forming the passivation film by performing the oxynitriding process on the surface layer of the silicon layer, a processing gas containing oxygen and nitrogen is introduced into a processing chamber during the CVD process and a ratio of the nitrogen to the oxygen in the introduced processing gas is gradually increased such that a content ratio of nitrogen atoms in the passivation film is gradually increased in a deposition direction.

16. A solar cell manufacturing apparatus comprising:
a processing unit for forming a passivation film on a surface layer of a silicon layer by performing an oxidation process, a nitridation process or an oxynitriding process on the surface layer of the silicon layer by using plasma.

17. The solar cell manufacturing apparatus of claim 16, wherein the processing unit forms the passivation film by using plasma having a sheath potential of about 10 eV or less.

18. The solar cell manufacturing apparatus of claim 16, wherein the processing unit forms the passivation film at a pressure ranging from about 6.67 Pa to about 6.67 × 10² Pa.

19. The solar cell manufacturing apparatus of claim 16, wherein the processing unit forms the passivation film at a temperature ranging from about 200°C to about 600°C.

20. The solar cell manufacturing apparatus of claim 16, wherein the plasma is surface wave plasma excited by a microwave.

21. The solar cell manufacturing apparatus of claim 20, wherein the processing unit includes a slot antenna for supplying the microwave.

22. The solar cell manufacturing apparatus of claim 20, wherein the microwave for generating the plasma is supplied intermittently in a pulse shape having a predetermined period.

23. The solar cell manufacturing apparatus of claim 16, wherein in case of performing the oxidation process on a surface layer of a polycrystalline silicon layer, a processing gas containing nitrogen is introduced into a processing chamber such that a nitrogen atom content ratio in an interface between the polycrystalline silicon layer and the passivation film is equal to or less than about 5 atomic%.

24. The solar cell manufacturing apparatus of claim 16, further comprising:
other processing unit for further forming a passivation film on the passivation film formed on the silicon layer by depositing an oxide film, a nitride film or an oxynitride film by a CVD process.

25. The solar cell manufacturing apparatus of claim 24, wherein the other processing unit forms the passivation film by the CVD process using plasma.

26. The solar cell manufacturing apparatus of claim 25, wherein the other processing unit includes a power supply for applying a bias power onto a deposition layer of the passivation film.

27. The solar cell manufacturing apparatus of claim 25, wherein in at least one of the oxidation process, the nitridation process or the oxynitriding process performed on the surface layer of the silicon layer in the processing unit and the CVD process performed in the other processing unit, a hydrogen gas is added to a processing gas.

28. The solar cell manufacturing apparatus of claim 24, the processing unit and the other processing unit are connected with each other via a transfer unit for transferring a solar cell substrate in a vacuum state.

29. The solar cell manufacturing apparatus of claim 24, wherein in case of forming the passivation film by performing the oxynitriding process on the surface layer of the silicon layer in the processing unit, a processing gas containing oxygen and nitrogen is introduced into a processing chamber during the CVD process performed in the other processing unit and a ratio of the nitrogen to the oxygen in the introduced processing gas is gradually increased such that a content ratio of nitrogen atoms in the passivation film is gradually increased in a deposition direction.
